# EUROPÄISCHE PATENTANMELDUNG

(11) **EP 4 757 077 A1**
(43) Veröffentlichungstag der Anmeldung: **10.06.2026**
(21) Anmeldenummer: 25219260.4
(22) Anmeldetag: 28.11.2025
(51) Int. Cl.: H01R 4/48

(54) **ELEKTRISCHE ANSCHLUSSVORRICHTUNG**

(30) Priorität: 06.12.2024 AT 1792024
(71) Anmelder: Getzner Textil Aktiengesellschaft, 6700 Bludenz (AT)
(72) Erfinder: Hierz, Alexander, 6822 Satteins (AT)
(74) Vertreter: Torggler & Hofmann Patentanwälte - Rankweil

(57) **Zusammenfassung**

Elektrische Anschlussvorrichtung (1) mit einem ersten elektrisch leitfähigen Draht (2) und einem, an dem ersten elektrisch leitfähigen Draht (2) elektrisch leitend fixierten Kontaktelement (3) zum Verbinden des ersten elektrisch leitfähigen Drahts (2) mit einem zweiten elektrisch leitfähigen Draht (4), wobei das Kontaktelement (3) eine elektrisch leitfähige Schraubenfeder (5) aufweist und der erste elektrisch leitfähige Draht (2) an einem stirnseitigen Ende (6) der Schraubenfeder (5) elektrisch leitend fixiert ist.

## Beschreibung

Die vorliegende Erfindung betrifft eine elektrische Anschlussvorrichtung mit einem ersten elektrisch leitfähigen Draht und einem, an dem ersten elektrisch leitfähigen Draht elektrisch leitend fixierten Kontaktelement zum Verbinden des ersten elektrisch leitfähigen Drahts mit einem zweiten elektrisch leitfähigen Draht. Darüber hinaus betrifft die Erfindung auch eine Anordnung mit einer solchen elektrischen Anschlussvorrichtung und die Verwendung einer solchen elektrischen Anschlussvorrichtung.

Beim Stand der Technik sind verschiedenste Technologien bekannt, wenn es darum geht, zwei elektrisch leitfähige Drähte elektrisch leitend miteinander zu verbinden. Insbesondere kommen hier verschiedene Arten von Kontaktelementen wie z.B. Lüsterklemmen, Crimpverbindungen, Lötstellen, Verschweißungen und dergleichen zum Einsatz. Insbesondere dann, wenn es darum geht, elektrisch leitfähige Drähte an Feuchtigkeitssensoren, Drucksensoren, Abschirmungen und dergleichen anzuschließen, sollte die Anschlussvorrichtung aber möglichst einfach bedienbar sein und ein schnelles und einfaches elektrisches Verbinden der beiden elektrisch leitfähigen Drähte miteinander ermöglichen.

Aufgabe der Erfindung ist es, eine hierfür besonders gut geeignete Art der elektrischen Anschlussvorrichtung zur Verfügung zu stellen.

Ausgehend von einer eingangs genannten elektrischen Anschlussvorrichtung sieht die Erfindung hierfür vor, dass das Kontaktelement eine elektrisch leitfähige Schraubenfeder aufweist und der erste elektrisch leitfähige Draht an einem stirnseitigen Ende der Schraubenfeder elektrisch leitend fixiert ist.

Mit der Erfindung ist es möglich, zwei elektrisch leitfähige Drähte besonders einfach und schnell, aber auch zuverlässig miteinander zu verbinden. Hierfür weist das Kontaktelement erfindungsgemäßer elektrischer Anschlussvorrichtungen eine elektrisch leitfähige Schraubenfeder auf. Durch einfaches Auseinanderziehen und wieder Loslassen der Schraubenfeder kann der zweite elektrisch leitfähige Draht zwischen den Windungen der Schraubenfeder eingeklemmt werden. Dies reicht aus, um die elektrische Verbindung zwischen dem am stirnseitigen Ende der Schraubenfeder angebrachten ersten elektrischen leitfähigen Draht der Anschlussvorrichtung und dem zweiten elektrisch leitfähigen Draht herzustellen. Der zweite elektrisch leitfähige Draht wird somit hierfür einfach zwischen den Windungen der Schraubenfeder eingeklemmt. Dadurch, dass der erste elektrisch leitfähige Draht am stirnseitigen Ende der Schraubenfeder elektrisch leitend fixiert ist, ist die elektrische Anschlussvorrichtung gemäß der Erfindung besonders gut handhabbar. Das Kontaktelement in Form der elektrisch leitfähigen Schraubenfeder befindet sich einfach zugänglich, sozusagen am vorderen Ende des ersten elektrisch leitfähigen Drahtes, welcher mit dem zweiten elektrisch leitfähigen Draht verbunden werden soll.

Das Kontaktelement kann dabei in besonders einfach herstellbaren Ausgestaltungsformen aus der Schraubenfeder bestehen, also keine weiteren Teile aufweisen. Um das Kontaktelement besonders gut greifen zu können, ist es aber auch denkbar, dass das Kontaktelement zusätzlich zur Schraubenfeder Griffelemente aufweist, welche z.B. auf einander gegenüberliegenden stirnseitigen Enden der Schraubenfeder an dieser befestigt sind.

Der erste elektrisch leitfähige Draht kann mittels verschiedener, an sich bekannter Verbindungsarten elektrisch leitend am stirnseitigen Ende der Schraubenfeder fixiert sein. Besonders bevorzugte Ausgestaltungsformen sehen hierbei vor, dass der erste elektrisch leitfähige Draht mittels einer Crimpverbindung oder einer Lötverbindung oder einer Schweißverbindung, z.B. durch Punktschweißen oder Ultraschallschweißen, an dem stirnseitigen Ende der Schraubenfeder elektrisch leitend fixiert ist. Die entsprechende Verbindung zwischen dem ersten elektrisch leitfähigen Draht und der Schraubenfeder kann bei Ausgestaltungsformen mit Griffelementen sogar innerhalb eines der Griffelemente angeordnet sein. Bei der Verbindung, mit der der erste elektrisch leitfähige Draht am stirnseitigen Ende der Schraubenfeder elektrisch leitend fixiert ist, handelt es sich günstigerweise um eine nicht zerstörungsfrei lösbare Verbindung. Trotzdem ist es auch denkbar, dass der erste elektrisch leitfähige Draht mittels einer lösbaren Verbindung wie z.B. einer Klemmschelle, Lüsterklemme oder dergleichen am stirnseitigen Ende der Schraubenfeder elektrisch leitend fixiert wird.

Die Begriffe elektrisch leitend bzw. elektrisch leitfähig bedeuten im Zusammenhang mit dieser Erfindung vorzugsweise, dass eine elektrische Leitfähigkeit von zumindest 1 x 10⁶ Siemens pro Meter (S/m), vorzugsweise von zumindest 30 x 10⁶ Siemens pro Meter, gegeben ist.

Die stirnseitigen Enden der Schraubenfeder sind die Endbereiche, die sich auf einander gegenüberliegenden Seiten an die Windungen der Schraubenfeder, vorzugsweise in Richtung der Längserstreckung der Schraubenfeder, anschließen.

Bei dem ersten elektrisch leitfähigen Draht wie auch bei dem zweiten elektrisch leitfähigen Draht handelt es sich grundsätzlich um längserstreckte linienförmige Körper, welche aus entsprechend elektrisch leitfähigem Material hergestellt sind. Dabei kann es sich um Metalldrähte wie z.B. Kupfer, Aluminium, Stahl, verschiedene Legierungen und dergleichen handeln. Der Begriff des Drahtes umfasst bei dieser Anmeldung aber auch entsprechende Ausgestaltungsformen, die nicht oder nur teilweise aus Metall bestehen. Es kann sich also auch um entsprechend elektrisch leitfähige Drähte aus oder mit Karbon, Kunststoff, insbesondere Polymer oder dergleichen handeln. Entsprechend leitfähige Polymere sind z.B. Poly-3,4-ethylendioxythiophen, Polyethin, Polyanilin, Polyparaphenylen, Polypyrol oder Polythiophen. Als elektrisch leitfähige Zusatzstoffe kann der jeweilige Draht z.B. Füllstoffe wie Ruß, Metall-Partikel oder andere elektrisch leitfähige Materialien enthalten. Sowohl der erste elektrisch leitfähige Draht als auch der zweite elektrisch leitfähige Draht kann jeweils aus einer einzigen Litze aber auch aus mehreren Litzen bestehen, welche dann vorzugsweise in an sich bekannter Art und Weise miteinander verdrillt sind. Sowohl der erste elektrisch leitfähige Draht als auch der zweite elektrisch leitfähige Draht können unisoliert, also nach außen hin nicht isoliert sein. Besonders beim ersten elektrisch leitfähigen Draht kann aber auch vorgesehen sein, dass dieser als Kabel, also mit einem elektrisch isolierenden Mantel ausgebildet ist.

Bevorzugt ist jedenfalls vorgesehen, dass der erste elektrisch leitfähige Draht und/oder auch der zweite elektrisch leitfähige Draht jeweils in sich flexibel ist bzw. sind. Beide Drähte sind günstigerweise von Hand biegbar, also von in sich starren Stangen, Rohren und dergleichen zu unterscheiden.

Um das Einklemmen des zweiten elektrisch leitfähigen Drahtes zwischen den Windungen der Schraubenfeder in einfacher Art und Weise realisieren zu können, ist es günstig, wenn man die Schraubenfeder von Hand von beiden Seiten bzw. Enden her greifen und zur Herstellung der Verbindung von Hand auseinanderziehen kann. Um das Kontaktelement bzw. die Schraubenfeder gut greifen zu können, ist günstigerweise vorgesehen, dass das Kontaktelement, vorzugsweise die Schraubenfeder eine Länge von zumindest 20 mm aufweist. Bei Ausgestaltungsformen, bei denen das Kontaktelement ausschließlich aus der Schraubenfeder besteht, weist die Schraubenfeder günstigerweise somit eine Länge von zumindest 20 mm auf. Hat das Kontaktelement aber stirnseitig an den Enden der Schraubenfeder angebrachte Griffelemente, so reicht es aus, wenn das gesamte Kontaktelement eine Länge von 20 mm aufweist. Die Schraubenfeder selbst kann dann auch kürzer sein.

Da das Kontaktelement aber nach dem Herstellen der elektrisch leitfähigen Verbindung mit dem zweiten elektrisch leitfähigen Draht an Ort und Stelle verbleibt, ist es auch günstig, wenn das Kontaktelement eine gewisse Höchstlänge nicht überschreitet, um nach Fertigstellung der Montage nicht weiter zu stören. In diesem Sinne ist es günstigerweise vorgesehen, dass das Kontaktelement, vorzugsweise die Schraubenfeder, eine Länge in einem Bereich von 20 mm bis 60 mm, vorzugsweise von 20 mm bis 40 mm, aufweist. Hat das Kontaktelement zusätzlich zur Schraubenfeder auch Griffelemente, so gilt dies günstigerweise für das Kontaktelement. Insbesondere bei Ausgestaltungsformen, bei denen das Kontaktelement nur aus der Schraubenfeder besteht, gilt dies günstigerweise für die Schraubenfeder.

Damit das nach dem Anschluss an Ort und Stelle verbleibende Kontaktelement nicht stört, ist in bevorzugten Ausgestaltungsformen vorgesehen oder auch vorgesehen, dass das Kontaktelement, vorzugsweise die Schraubenfeder, einen Außendurchmesser in einem Bereich von 2,5 mm bis 4,5 mm aufweist. In anderen Worten ist es somit günstig, wenn das Kontaktelement relativ dünn ausgeführt ist. Der Drahtdurchmesser der Windungen der Schraubenfeder liegt vorzugsweise überall in einem Bereich von 0,4 mm bis 1 mm, vorzugsweise von 0,55 mm bis 0,75 mm. Die Anzahl der Windungen der Schraubenfeder liegt bevorzugt in einem Bereich von 20 bis 150. Die Schraubenfeder bzw. deren Windungen können aus Federstahl, rostfreiem Federstahl, Kupferlegierung, Kohlenstoffstahl wie z.B. (C75, C85, C100) 1.1200 / 1.1248 / 1.1269 / 1.1274, Inox wie z.B. (301, 316, 17-7 PH) 1.4210 / 1.4401 / 1.4568, Inconel (X750, 718, 625, 600) 2.4669 / 2.4668 / 2.4856 / 2.4816, Hastelloy wie z.B. (C4, C276) 2.4610 / 2.4819 , das körperimplantierbare MP35N, Beryllium-Kupfer wie z.B. 2.1247, Phosphor-Bronze wie z.B. 2.1020 oder auch Messing wie z.B. 2.0321 bestehen, nur um einige Beispiele zu nennen. Allgemein gesprochen, sollte die Schraubenfeder aus einem entsprechend elastischen und elektrisch leitfähigen Material oder einer entsprechenden Materialzusammensetzung bestehen.

Um einerseits eine einfache Kontaktierung von Hand zu ermöglichen und um andererseits aber auch eine dauerhafte sichere Kontaktierung zu gewährleisten, sehen bevorzugte Varianten der Erfindung vor, dass eine Federkonstante einer Windung der Schraubenfeder in einem Bereich von 5 bis 90 Newton pro Millimeter (N/mm), vorzugsweise von 7,5 bis 86 Newton pro Millimeter, liegt. Die Federkonstante der Schraubenfeder liegt bevorzugt in einem Bereich von 0,05 bis 4,3 Newton pro Millimeter.

Günstigerweise ist vorgesehen, dass eine, auf einen, zwischen den Windungen der Schraubenfeder eingeklemmten, Gegenstand von der Schraubenfeder ausgeübte, Klemmkraft in einem Bereich von 8 Newton bis 13 Newton liegt. Dies gilt insbesondere günstigerweise dann, wenn der zwischen den Windungen der Schraubenfeder eingeklemmte Gegenstand einen Durchmesser im Bereich von 0,15 mm bis 0,4 mm aufweist.

Neben der elektrischen Anschlussvorrichtung an sich betrifft die Erfindung auch eine Anordnung mit einer erfindungsgemäßen elektrischen Anschlussvorrichtung und dem zweiten elektrisch leitfähigen Draht, wobei der zweite elektrisch leitfähige Draht zur Ausbildung einer elektrisch leitfähigen Verbindung mit dem ersten elektrisch leitfähigen Draht zwischen zwei Windungen der Schraubenfeder eingeklemmt ist. Bei einer solchen Anordnung kann die elektrische Anschlussvorrichtung gemäß allen hier geschilderten Ausgestaltungsformen ausgeführt sein.

Bevorzugt kommt die elektrische Anschlussvorrichtung gemäß der Erfindung dann zum Einsatz, wenn es darum geht, zweite elektrisch leitfähige Drähte, welche an einem textilen Flächengebilde fixiert sind, zu kontaktieren. Insofern betrifft die erfindungsgemäße Anordnung günstigerweise solche Anordnungen, bei denen der zweite elektrisch leitfähige Draht an einem textilen Flächengebilde fixiert ist. Das textile Flächengebilde kann dabei Teil der Anordnung und/oder Teil eines Feuchtigkeitssensors und/oder eines Drucksensors und/oder einer Abschirmung und/oder einer Antenne und/oder eines Heizgewebes sein, um nur einige der möglichen Anwendungen zu nennen. Insofern betrifft die Erfindung auch einen Feuchtigkeitssensor und/oder einen Drucksensor und/oder eine Abschirmung und/oder eine Antenne und/oder ein Heizgewebe. Der zweite elektrisch leitfähige Draht kann jedenfalls in das textile Flächengebilde eingewoben oder in anderer Art und Weise an diesem fixiert sein. Günstigerweise weist der zweite elektrisch leitfähige Draht einen Durchmesser im Bereich von 0,15 mm bis 0,4 mm auf. Um das Kontaktelement in einfacher Art und Weise mit dem, am textilen Flächengebilde fixierten, zweiten elektrisch leitfähigen Draht verbinden zu können, ist bevorzugt vorgesehen, dass der zweite elektrisch leitfähige Draht nur an voneinander beabstandeten Stellen am textilen Flächengebilde fixiert ist und dazwischen freiliegt. In den freiliegenden Bereichen ist dann eine Verbindung des Kontaktelements mit dem zweiten elektrisch leitfähigen Draht einfach möglich.

Zusätzlich zum bisher Gesagten betrifft die Erfindung auch noch eine Verwendung einer erfindungsgemäßen Anschlussvorrichtung zur Ausbildung einer elektrisch leitfähigen Verbindung des ersten elektrisch leitfähigen Drahts mit dem zweiten elektrisch leitfähigen Draht, wobei der zweite elektrisch leitfähige Draht zwischen zwei Windungen der Schraubenfeder eingeklemmt wird. Bei dieser Verwendung ist in bevorzugten Ausgestaltungsformen vorgesehen, dass der zweite elektrisch leitfähige Draht bereits vor dem Verbinden mit dem ersten elektrisch leitfähigen Draht an einem textilen Flächengebilde fixiert ist. Das textile Flächengebilde kann auch hier Teil der Anordnung und/oder eines Feuchtigkeitssensors und/oder eines Drucksensors und/oder einer Abschirmung und/oder einer Antenne und/oder eines Heizgewebes sein. In besonders bevorzugten Ausgestaltungsformen ist der zweite elektrisch leitfähige Draht bereits vor dem Verbinden mit dem ersten elektrisch leitfähigen Draht in das textile Flächengebilde eingewoben. Auch hier weist der zweite elektrisch leitfähige Draht bevorzugt einen Durchmesser im Bereich von 0,15 mm bis 0,4 mm auf.

Bei den obigen und auch nachfolgenden Schilderungen der Erfindung und ihren bevorzugten Ausgestaltungsformen wird in der Regel die Minimalanzahl der vorhandenen Teile bzw. Merkmale genannt. Dies heißt aber nicht, dass nicht einzelne Merkmale bzw. Teile mehrfach vorhanden sein können. Insofern sind Zahlwörter wie ein, zwei, drei, usw. soweit dies nicht widersprüchlich ist, grundsätzlich als genau ein, genau zwei, genau drei, usw., aber auch als zumindest ein, zumindest zwei oder zumindest drei usw. zu verstehen. Die gegebenenfalls im Singular genannten Merkmale können also auch mehrfach vorhanden sein, um so andere erfindungsgemäße Ausgestaltungsformen bereitzustellen.

Nachfolgend werden bevorzugte Ausgestaltungsformen der Erfindung exemplarisch anhand von Ausführungsbeispielen erläutert. Es zeigen:
- Fig. 1: ein erstes erfindungsgemäßes Ausführungsbeispiel einer elektrischen Anschlussvorrichtung;
- Fig.2: ein zweites erfindungsgemäßes Ausführungsbeispiel einer elektrischen Anschlussvorrichtung;
- Fig. 3: eine erfindungsgemäße Anordnung unter Verwendung des ersten Ausführungsbeispiels gemäß Fig. 1;
- Fig. 4: eine Prinzipskizze zur Verbindung der Schraubenfeder mit dem zweiten elektrisch leitfähigen Draht;
- Fig. 5: eine Symboldarstellung für eine erfindungsgemäße Anordnung, bei der mehrere erfindungsgemäße elektrische Anschlussvorrichtungen verwendet werden und
- Fig. 6: einen Querschnitt durch eine Decke eines Gebäudes, in der eine erfindungsgemäße Anordnung zum Einsatz kommen kann.

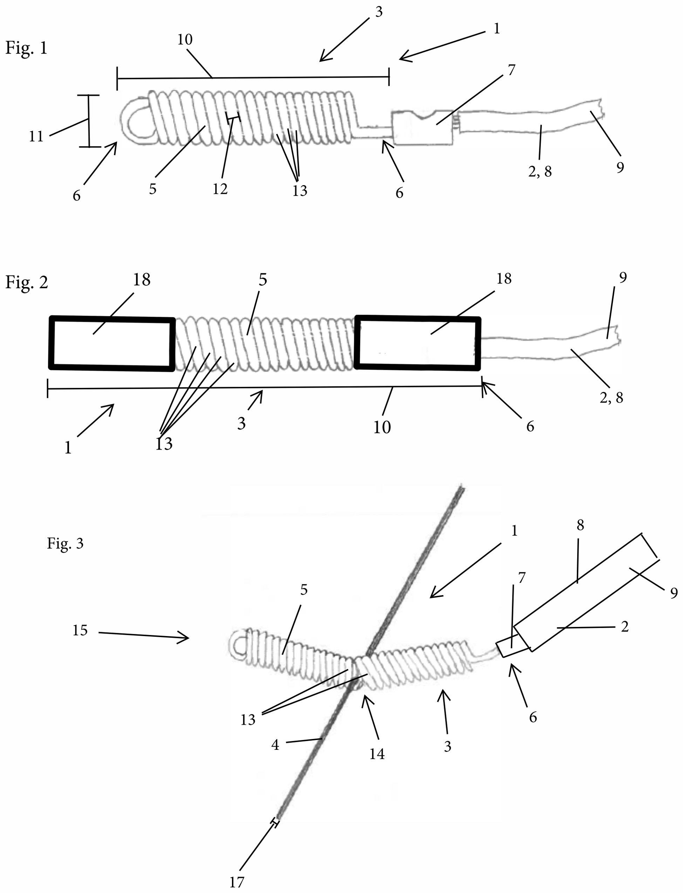

Fig. 1 zeigt ein erstes erfindungsgemäßes Ausführungsbeispiel einer elektrischen Anschlussvorrichtung 1. Diese umfasst einen ersten elektrisch leitfähigen Draht 2 und ein an dem ersten elektrisch leitfähigen Draht 2 elektrisch leitend fixiertes Kontaktelement 3. Das Kontaktelement 3 dient, wie weiter hinten noch gezeigt und beschrieben, der elektrisch leitfähigen Verbindung 14 des ersten elektrisch leitfähigen Drahts 2 mit einem zweiten elektrisch leitfähigen Draht 4, siehe Fig. 3. In diesem Ausführungsbeispiel ist das Kontaktelement 3 als eine elektrisch leitfähige Schraubenfeder 5 ausgebildet. Das Kontaktelement 3 besteht in dieser Ausführungsform gemäß Fig. 1 also ausschließlich aus der Schraubenfeder 5. Der erste elektrisch leitfähige Draht ist an dem stirnseitigen Ende 6 der Schraubenfeder 5 elektrisch leitend fixiert. Diese Fixierung ist in diesem ersten Ausführungsbeispiel gemäß Fig. 1 als eine Crimpverbindung 7 ausgeführt. Crimpverbindungen sind an sich bekannt.

Bei dem ersten elektrisch leitfähigen Draht 2 in Fig. 1 handelt es sich um ein Kabel 8 mit einem elektrisch isolierenden Mantel 9. Der erste elektrisch leitfähige Draht 2 ist in sich flexibel und von Hand biegbar. Die Länge 10 des Kontaktelements 3, bzw. in Fig. 1 der Schraubenfeder 5, beträgt in bevorzugten Ausgestaltungsformen zumindest 20 mm. Um auch nicht zu groß und damit störend zu sein, liegt die Länge 10 bevorzugt in einem Bereich von 20 mm bis 60 mm, vorzugsweise von 20 mm bis 40 mm. Da das Kontaktelement 3 nach dem Anschließen des ersten elektrisch leitfähigen Drahtes 2 an den zweiten elektrisch leitfähigen Draht 4 vor Ort verbleibt, ist es günstigerweise auch relativ schlank ausgeführt. Hierzu weist es bevorzugt einen Außendurchmesser 11 in einem Bereich von 2,5 mm bis 4,5 mm auf. Der Drahtdurchmesser 12 der jeweiligen Windung 13 der Schraubenfeder 5 liegt günstigerweise in einem Bereich von 0,4 mm bis 1 mm, vorzugsweise von 0,55 mm bis 0,75 mm.

Fig. 2 zeigt eine ebenfalls erfindungsgemäße Abwandlungsform des ersten Ausführungsbeispiels. Hier weist das Kontaktelement 3 zusätzlich zur Schraubenfeder 5 noch an deren stirnseitigen Enden angebrachte Griffelemente 18 auf. Während der Benutzer zum Anschließen an den zweiten elektrisch leitfähigen Draht 4 das Kontaktelement 3 aus dem Ausführungsbeispiel gemäß Fig. 1 direkt an der Schraubenfeder 5 bzw. deren stirnseitigen Enden 6 angreift, kann der Benutzer bei der Variante gemäß Fig. 2 mit seinen Händen 19 die Griffelemente 18 greifen, um so die nachfolgend noch beschriebene Montage auszuführen.

Bei Ausführungsbeispielen wie in Fig. 2, bei denen das Kontaktelement 3 zusätzlich zur Schraubenfeder 5 auch Griffelemente 18 aufweist, reicht es aus, wenn die Länge 10 des gesamten Kontaktelements 3, also inklusive der Griffelemente 18, in den oben bezeichneten Bereichen liegt. Die Schraubenfeder 5 kann bei solchen Varianten also kürzer ausgeführt sein.

Die elektrisch leitfähige Fixierung des ersten elektrisch leitfähigen Drahtes 2 am stirnseitigen Ende 6 der Schraubenfeder 5 kann, wie in Fig. 2 gezeigt, innerhalb des Griffelements 18 ausgeführt sein. Hier kann es sich um eine Crimpverbindung 7, wie in Fig. 1, handeln, auch wenn diese von außen nicht zu sehen ist. Alternativ zur Crimpverbindung 7 sind, wie auch in anderen Ausführungsbeispielen, insbesondere innerhalb des Griffelements 18 aber auch Lötverbindungen, Schweißverbindungen oder dergleichen möglich, um den ersten elektrisch leitfähigen Draht 2 elektrisch leitend an der Schraubenfeder 5 bzw. deren stirnseitigem Ende 6 zu befestigen. Grundsätzlich könnte es sich an dieser Stelle auch um lösbare Verbindungen wie z.B. eine Klemmverbindung oder eine Schraubklemmverbindung handeln. In der Regel reicht aber eine nur durch Zerstörung lösbare, aber eben recht einfach und kostengünstig herstellbare Crimpverbindung 7 oder Lötverbindung oder Schweißverbindung aus, um den elektrisch leitfähigen Draht 2 am stirnseitigen Ende 6 der Schraubenfeder 5 elektrisch leitend zu fixieren.

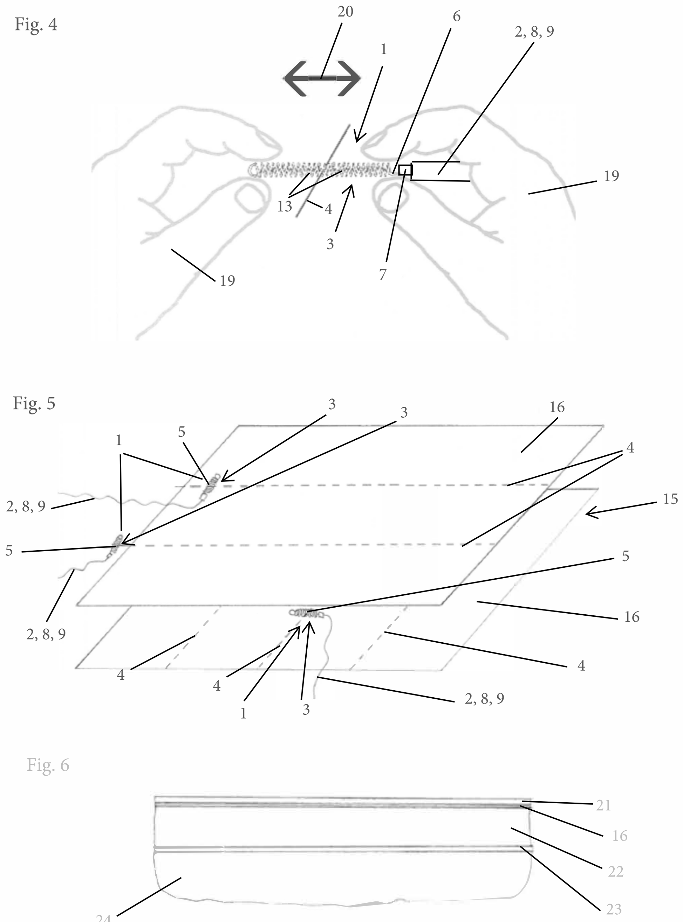

Fig. 3 zeigt nun eine Ausführungsvariante einer erfindungsgemäßen Anordnung 15, bei der eine elektrische Anschlussvorrichtung 1 gemäß des ersten Ausführungsbeispiels aus Fig. 1 verwendet wird, um den ersten elektrisch leitfähigen Draht 2 mit dem zweiten elektrisch leitfähigen Draht 4 elektrisch leitend zu verbinden. Hierzu wird der zweite elektrisch leitfähige Draht 4, wie in Fig. 3 gut zu sehen, zwischen zwei Windungen 13 der Schraubenfeder 5 eingeklemmt. Der zweite elektrisch leitfähige Draht 4 kann unterschiedliche Durchmesser 17 aufweisen. Bevorzugt liegen diese aber in einem Bereich zwischen 0,15 mm und 0,4 mm. Jedenfalls ist mit einer Anordnung 15 gemäß Fig. 3 eine dauerhafte und elektrisch sicher kontaktierte Verbindung zwischen dem ersten elektrisch leitfähigen Draht 2 und dem zweiten elektrisch leitfähigen Draht 4 geschaffen. Um diese Verbindung herzustellen, reicht es, wie in Fig. 4 symbolisch dargestellt, aus, mit den Händen 19 das Kontaktelement 3 bzw. hier die Schraubenfeder 5 zu greifen, in Richtung des Doppelpfeils 20 auseinander zu ziehen und dann so über den zweiten elektrisch leitfähigen Draht 4 zu stecken, dass dieser nach dem Loslassen der Enden des Kontaktelements 3, wie in Fig. 3 gezeigt, zwischen zwei benachbarten Windungen 13 der Schraubenfeder 5 eingeklemmt ist. Eine solche Verbindung ist einfach herstellbar, dauerhaft haltbar und stellt eine ausreichend gute elektrisch leitende Verbindung auch über größere Zeiträume sicher.

Andererseits ist eine solche Verbindung aber auch einfach wieder lösbar, indem man mit den Händen 19 die entsprechenden Enden des Kontaktelements 3 greift und auseinanderzieht, sodass das Kontaktelement 3 mit seiner Schraubenfeder 5 dann in einfacher Art und Weise wieder von dem zweiten elektrisch leitfähigen Draht 4 getrennt werden kann. Die in Fig. 3 dargestellte elektrisch leitfähige Verbindung 14 ist somit mittels erfindungsgemäßer elektrischer Anschlussvorrichtung 1 einfach herstellbar und auch wieder trennbar.

Damit diese elektrisch leitfähige Verbindung 14 einerseits einfach herstellbar ist, andererseits aber auch dauerhaft beständig ist, liegt die Federkonstante einer Windung der Schraubenfeder 5 bevorzugt in einem Bereich von 5 bis 90 Newton pro Millimeter (N/mm), vorzugsweise von 7,5 bis 86 Newton pro Millimeter. Die Federkonstante der Schraubenfeder liegt bevorzugt in einem Bereich von 0,05 bis 4,3 Newton pro Millimeter. Die auf den, zwischen den Windungen 13 der Schraubenfeder 5 eingeklemmten, Gegenstand also den zweiten elektrisch leitfähigen Draht 4 von der Schraubenfeder 5 ausgeübte Klemmkraft liegt günstigerweise im Bereich von 8 Newton bis 13 Newton.

Wie eingangs bereits erwähnt, können elektrische Anschlussvorrichtungen 1 gemäß der Erfindung dazu verwendet werden, zweite elektrisch leitfähige Drähte 4, welche an textilen Flächengebilden 16 fixiert sind, mit dem ersten elektrisch leitfähigen Draht 2 zu verbinden. Eine solche Anordnung ist z.B. in Fig. 5 gezeigt. Diese textilen Flächengebilde 16 können z.B. Teil eines Feuchtigkeitssensors oder eines Drucksensors oder einer Abschirmung und/oder einer Antenne oder eines Heizgewebes sein. In Fig. 5 sind zwei übereinander angeordnete Flächengebilde 16 dargestellt, welche jeweils Teil eines an sich bekannten Feuchtigkeitssensors sind. Die an ihnen fixierten zweiten elektrisch leitfähigen Drähte 4 verlaufen in den verschiedenen Ebenen in zueinander gekreuzten Ausrichtungen, so wie dies für entsprechende Feuchtigkeitssensoren an sich bekannt ist. Zur Ausbildung der elektrisch leitfähigen Verbindungen 14 des jeweiligen ersten elektrisch leitfähigen Drahts 2 mit dem jeweiligen zweiten elektrisch leitfähigen Draht 4 wird der jeweilige zweite elektrisch leitfähige Draht 4 zwischen zwei Windungen 13 der jeweils in den Fig. 5 auch dargestellten Schraubenfeder 5 in der bereits beschriebenen Art und Weise eingeklemmt. Hierdurch können die verschiedenen zweiten elektrisch leitfähigen Drähte 4 in dem textilen Flächengebilde 16 schnell und unproblematisch kontaktiert werden. Die zweiten elektrisch leitfähigen Drähte 4 sind günstigerweise bereits vor dem Verbinden mit den ersten elektrisch leitfähigen Drähten 2 in das textile Flächengebilde 16 eingewoben. Zwischen den Stellen, an denen der jeweilige zweite elektrisch leitfähige Draht 4 am jeweiligen textilen Flächengebilde 16 befestigt ist, liegt der jeweilige elektrisch leitfähige Draht 4 frei, sodass er dort besonders gut mittels des Kontaktelements 3 anschließbar ist.

Die Erfindung hat den Vorteil, dass die Kontaktierung mittels der elektrischen Anschlussvorrichtung 1 quasi überall entlang des zweiten elektrisch leitfähigen Drahtes 4 dort vorgenommen werden kann, wo er entsprechend aus dem textilen Flächengebilde 16 herausragt. Die Kontaktierung geht einfach und werkzeuglos vor sich und ist in einfacher Art und Weise, wie beschrieben, auch wieder zerstörungsfrei lösbar.

Um Elektrokorrosion zu vermeiden, besitzen die für den ersten elektrisch leitfähigen Draht 2, den zweiten elektrisch leitfähigen Draht 4 und die Schraubenfeder 5 verwendeten Materialien günstigerweise die gleiche oder eine ähnliche Position in der elektrochemischen Spannungsreihe. Das Kontaktelement 3 bzw. die Schraubenfeder 5 kann im fertig montierten Zustand in horizontaler aber auch in vertikaler Richtung auf dem textilen Flächengebilde 16 angeordnet sein. Nach dem Herstellen der elektrisch leitfähigen Verbindung zwischen dem ersten elektrisch leitfähigen Draht 2 und dem zweiten elektrisch leitfähigen Draht 4 mittels der erfindungsgemäßen elektrischen Anschlussvorrichtung 1 kann diese Verbindung 14 noch durch Lack wie z.B. Silikonharz, selbstklebendem Schrumpfschlauch oder eine andere geeignete Überdeckung gegen Korrosionen geschützt werden.

Wie in Fig. 6 in einem Schnitt durch einen Deckenaufbau beispielhaft gezeigt, kann das textile Flächengebilde 16 mit den in Fig. 6 nicht explizit gezeigten elektrischen Anschlussvorrichtungen 1 aber auch einfach mittels einer oder mehrerer Dachbahnen 21 überdeckt werden. Insbesondere bei der Verwendung als Feuchtigkeitssensor ist das textile Flächengebilde 16 unter der Lage aus Dachbahnen 21 z.B. auf einer Dämmplatte 22 angebracht, welche wiederum auf einer Dampfsperre 23 lagert. Unter der Dampfsperre 23 befindet sich die Betondecke 24. Fig. 6 zeigt lediglich eine der möglichen Aufbauten, ohne die Verwendung der erfindungsgemäßen elektrischen Anschlussvorrichtung 1 in irgendeiner Form zu limitieren.

### L e g e n d e zu den Hinweisziffern:

- 1: elektrische Anschlussvorrichtung
- 2: erster elektrisch leitfähiger Draht
- 3: Kontaktelement
- 4: zweiter elektrisch leitfähiger Draht
- 5: Schraubenfeder
- 6: stirnseitiges Ende
- 7: Crimpverbindung
- 8: Kabel
- 9: Mantel
- 10: Länge
- 11: Außendurchmesser
- 12: Drahtdurchmesser
- 13: Windung
- 14: elektrisch leitfähige Verbindung
- 15: Anordnung
- 16: textiles Flächengebilde
- 17: Durchmesser
- 18: Griffelement
- 19: Hand
- 20: Doppelpfeil
- 21: Dachbahn
- 22: Dämmplatte
- 23: Dampfsperre
- 24: Betondecke

## Patentansprüche

1. Elektrische Anschlussvorrichtung (1) mit einem ersten elektrisch leitfähigen Draht (2) und einem, an dem ersten elektrisch leitfähigen Draht (2) elektrisch leitend fixierten Kontaktelement (3) zum Verbinden des ersten elektrisch leitfähigen Drahts (2) mit einem zweiten elektrisch leitfähigen Draht (4), **dadurch gekennzeichnet, dass** das Kontaktelement (3) eine elektrisch leitfähige Schraubenfeder (5) aufweist und der erste elektrisch leitfähige Draht (2) an einem stirnseitigen Ende (6) der Schraubenfeder (5) elektrisch leitend fixiert ist.

2. Elektrische Anschlussvorrichtung (1) nach Anspruch 1, wobei das Kontaktelement (3) aus der Schraubenfeder (5) besteht.

3. Elektrische Anschlussvorrichtung (1) nach einem der Ansprüche 1 oder 2, wobei das Kontaktelement (3), vorzugsweise die Schraubenfeder (5), eine Länge (10) von zumindest 20 mm aufweist.

4. Elektrische Anschlussvorrichtung (1) nach einem der Ansprüche 1 bis 3, wobei das Kontaktelement (3), vorzugsweise die Schraubenfeder (5), einen Außendurchmesser (11) in einem Bereich von 2,5 mm bis 4,5 mm aufweist.

5. Elektrische Anschlussvorrichtung (1) nach einem der Ansprüche 1 bis 4, wobei eine Federkonstante einer Windung der Schraubenfeder (5) in einem Bereich von 5 bis 90 Newton pro Millimeter, vorzugsweise von 7,5 bis 86 Newton pro Millimeter, liegt.

6. Elektrische Anschlussvorrichtung (1) nach einem der Ansprüche 1 bis 5, wobei eine, auf einen, zwischen den Windungen (13) der Schraubenfeder (5) eingeklemmten, Gegenstand von der Schraubenfeder (5) ausgeübte, Klemmkraft in einem Bereich von 8 Newton bis 13 Newton liegt.

7. Anordnung (15) mit einer elektrischen Anschlussvorrichtung (1) nach einem der Ansprüche 1 bis 6 und dem zweiten elektrisch leitfähigen Draht (4), wobei der zweite elektrisch leitfähige Draht (4) zur Ausbildung einer elektrisch leitfähigen Verbindung (14) mit dem ersten elektrisch leitfähigen Draht (2) zwischen zwei Windungen (13) der Schraubenfeder (5) eingeklemmt ist.

8. Anordnung (15) nach Anspruch 7, wobei der zweite elektrisch leitfähige Draht (4) an einem textilen Flächengebilde (16) fixiert ist.

9. Anordnung (15) nach Anspruch 8, wobei das textile Flächengebilde (16) Teil eines Feuchtigkeitssensors und/oder eines Drucksensors und/oder einer Abschirmung und/oder einer Antenne und/oder eines Heizgewebes ist.

10. Anordnung (15) nach Anspruch 8 oder 9, wobei der zweite elektrisch leitfähige Draht (4) in das textile Flächengebilde (16) eingewoben ist.

11. Verwendung einer elektrischen Anschlussvorrichtung (1) nach einem der Ansprüche 1 bis 6 zur Ausbildung einer elektrisch leitfähigen Verbindung (14) des ersten elektrisch leitfähigen Drahts (2) mit dem zweiten elektrisch leitfähigen Draht (4), wobei der zweite elektrisch leitfähige Draht (4) zwischen zwei Windungen (13) der Schraubenfeder (5) eingeklemmt wird.

12. Verwendung nach Anspruch 11, wobei der zweite elektrisch leitfähige Draht (4) bereits vor dem Verbinden mit dem ersten elektrisch leitfähigen Draht (2) an einem textilen Flächengebilde (16) fixiert ist.

13. Verwendung nach Anspruch 12, wobei das textile Flächengebilde (16) Teil eines Feuchtigkeitssensors und/oder eines Drucksensors und/oder einer Abschirmung und/oder einer Antenne und/oder eines Heizgewebes ist.

14. Verwendung nach Anspruch 12 oder 13, wobei der zweite elektrisch leitfähige Draht (4) bereits vor dem Verbinden mit dem ersten elektrisch leitfähigen Draht (2) in das textile Flächengebilde (16) eingewoben ist.

15. Verwendung nach einem der Ansprüche 11 bis 14, wobei der zweite elektrisch leitfähige Draht (4) einen Durchmesser (17) im Bereich von 0,15 mm bis 0,4 mm aufweist.
